# EUROPEAN PATENT APPLICATION

(11) **EP 1 691 402 A1**
(43) Date of publication of application: **16.08.2006**
(21) Application number: 04819793.3
(22) Date of filing: 26.11.2004
(51) Int. Cl.: H01L 21/3065

(54) **PLASMA ETCHING METHOD**

(30) Priority: 01.12.2003 JP 2003402110; 01.12.2003 JP 2003401876; 25.11.2004 JP 2004340752
(71) Applicant: MATSUSHITA ELECTRIC INDUSTRIAL CO., LTD., Osaka 571-8501 (JP)
(72) Inventor: OKUNE, Mitsuhiro c/o Matsushita Elect. Ind. Co, Lt, Chuo-ku Osaka-shi Osaka 540-6319 (JP); HIROSHIMA Mitsuru Matsushita Elect. Ind. Co, Ltd, Chuo-ku Osaka-shi Osaka 540-6319 (JP); SUZUKI Hiroyuki c/o Matsushita Elect. Ind. Co, Ltd, Chuo-ku Osaka-shi Osaka 540-6319 (JP); MIYAKE Sumio c/o Matsushita Elect. Ind. Co, Ltd, Chuo-ku Osaka-shi Osaka 540-6319 (JP); WATANABE Shouzou Matsushita Elect. Ind. Co, Ltd, Chuo-ku Osaka-shi Osaka 540-6319 (JP)
(74) Representative: Pautex Schneider, Nicole Véronique
(86) International application number: PCT/JP2004/017622
(87) International publication number: WO 2005/055303

(57) **Abstract**

An object of the present invention is to provide a plasma etching method by which both of a requirement for a trench shape and a requirement for a aspect ratio can be satisfied, and a trench having a side wall of a smooth shape can be formed. According to the present invention, a silicon substrate is placed on a lower electrode (120), etching gas is supplied through a gas introducing port (140) and exhausted from an exhaust port (150), high frequency powers (130a, 130b) supply high-frequency electricity to an upper electrode (110) and a lower electrode (120), respectively, in order to energize the etching gas into plasma state, using an ICP method, and then activated species are generated to make etching of the silicon substrate be progressed. As the etching gas, mixed gas, which includes mainly SF₆ gas added with O₂ gas and He gas, is used.

## Description

### Technical Field

The present invention relates to a plasma etching method, and particularly to a plasma etching method for forming a trench satisfactorily.

### Background Art

In recent years, with miniaturization of electronic apparatuses, semiconductor devices corresponding to the apparatuses have been also required to be miniaturized. Therefore, with the aim of element separation of a semiconductor device and securing of a memory cell capacity area, a trench (ditch) and a via hole (hole), which are formed in a silicon substrate, are required to have a high aspect ratio (depth of the ditch or the hole / diameter of the ditch or the hole) that is, for example, equal to or more than 40. Moreover, as a method of forming the trench and the via hole having such a high aspect ratio, there is a plasma etching method by which, using activated species (ion and radical) generated by energizing etching gas into plasma state, etching of a silicon substrate is performed. Plasma etching mechanisms for the trench and the via hole are the almost same, so that the following description is given for the trench.

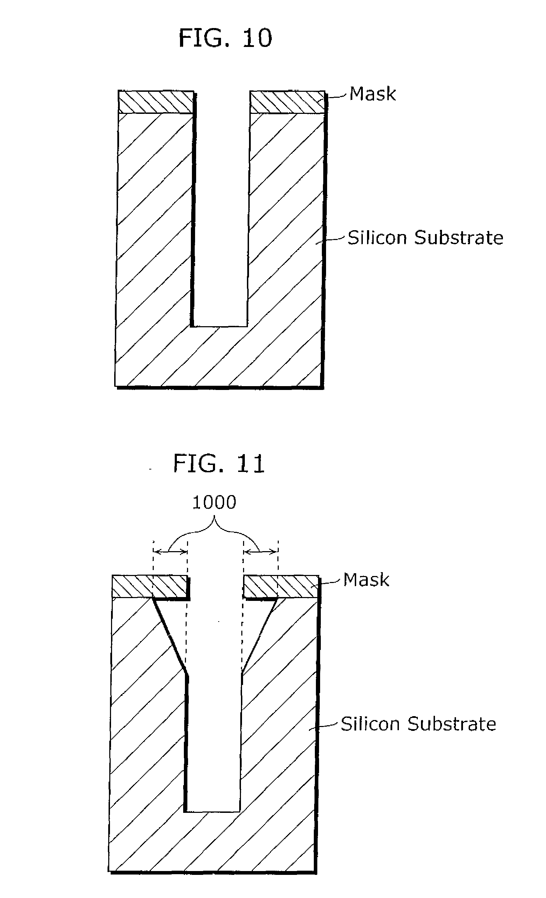

In the meantime, the trench is required to have the high aspect ratio, and also required to have an angle of inclination of a side wall part as shown in FIG. 10 at about 90 degrees (vertical). However, when the trench having the high aspect ratio is to be realized, shape control of the trench becomes difficult, so that there is a problem that it is not possible to satisfy both of the requirement for the trench shape and the requirement for the aspect ratio. More specifically, in an etching process of a silicon substrate by the plasma etching method, radical which is electrically neutral isotropically enters a surface of the silicon substrate, and causes side etching, so that especially for the trench having the high aspect ratio, this side etching becomes significant, which results in that the trench shape is not a predetermined shape but a shape as shown in FIG. 11.

As prior arts for solving such a problem, there are, for example, plasma etching methods described in patent documents 1 and 2.

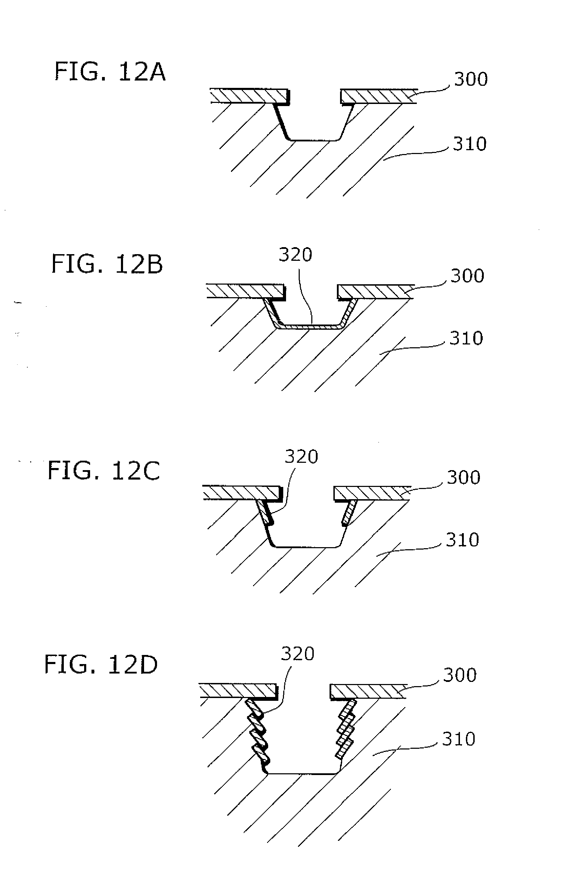

The following describes etching of a silicon substrate by the plasma etching method described in the patent documents 1 and 2, with reference to FIGS. 12A to 12D.

Firstly, as shown in FIG. 12A, using a mask 300 by which a pattern is formed, by activated species generated by energizing etching gas into plasma state, etching of a silicon substrate 310 is performed. Here, an ion is accelerated by negative bias, vertically enters a surface of a silicon substrate 310, and makes etching progressed in a vertical direction, while radical isotropically enters the surface of the silicon substrate 310 and causes side etching below the mask 300 of an upper end aperture.

Next, as shown in FIG. 12B, a protection film 320 for etching is formed on a surface of the silicon substrate 310 in a trench.

Next, as shown in FIG. 12C, etching of the silicon substrate 310 is further performed by the activated species. Here, a trench sidewall is covered with the protection film 320, so that etching of the side surface by the radical is not progressed, but etching in a vertical direction and etching of a newly appeared trench side wall are progressed.

Next, as shown in FIG. 12D, the above processes of FIGS. 12A to 12C are repeated.
As described above, according to the conventional plasma etching method, the etching process is performed by being divided into a plurality of times, and prior to progress of the etching, the trench sidewall is covered with the protection film. Thereby, by increasing the number of the etching, a trench having a high aspect ratio can be formed, and progress of the etching to the trench sidewall can be restrained, so that it is possible to satisfy both of the requirement for the trench shape and the requirement for the aspect ratio.
Patent document 1: Japanese Patent Laid-Open No. 60-50923 publication
Patent document 2: Japanese Patent Laid-Open No. 7-503815 publication

### Disclosure of Invention

### Problem to be Solved by the Invention

However, the conventional plasma etching method has a problem that the etching process and the process of the protection film forming are repeatedly performed, which results in causing unevenness of the trench side wall.

Accordingly, in view of the problems, an object of the present invention is to provide a plasma etching method which makes it possible to satisfy both the requirement for the trench shape and the requirement for the aspect ratio, and also possible to form a trench having a side wall of a smooth shape.

### Means to Solve the Problem

In order to achieve the above object, a plasma etching method of performing plasma etching to an object made of silicon in a treatment chamber includes: introducing, into the treatment chamber, etching gas which includes fluorine compound gas and rare gas; and etching the object by energizing the etching gas into plasma state. Here, the etching gas may further include one of oxygen (O₂) gas, carbon monoxide (CO) gas, and carbon dioxide (CO₂) gas, and the fluorine compound gas may be sulfur hexafluoride (SF₆) gas, the rare gas may be helium (He) gas, a volume of the helium (He) gas introduced into the treatment chamber may be equal to or more than 30% of a total flow rate of the etching gas, and the etching gas may be energized into plasma state, by an inductively coupled plasma (ICP) method.

By the above structures, it is possible to generate gas flow by which gas inside the trench is removed to the outside, and to shorten a stay time of reaction products and activated species inside the trench, so that even when the trench having the high aspect ratio is formed, it is possible to restrain situations where side etching occurs in the trench or where the trench tapers. This means that it is possible to realize a plasma etching method by which both the requirement for the trench shape and the requirement for the aspect ratio can be satisfied. Moreover, by a single etching process, a trench can be formed in the silicon substrate, which prevents occurrence of the unevenness of the trench side wall. This means that it is possible to realize a plasma etching method by which a trench having a side wall of a smooth shape can be formed.

Here, an inside wall of the treatment chamber may be made of an insulating material. Further, the insulating material may be one of quartz, alumina, an aluminum matrix with alumite treatments, yttrium oxide, silicon carbide, and aluminum nitride.

Thereby, a plasma density is kept high, and an etching rate is maintained high, so that it is possible to prevent from reduction of a side wall protection effect for the trench, which makes it possible to realize a plasma etching method by which the side etching is not occurred in the trench and a trench of a predetermined shape can be formed.

Further, the etching gas may further include chlorine (Cl₂) gas. Further, a volume of the chlorine (Cl₂) gas introduced into the treatment chamber may be equal to or less than 10% of a total flow rate of the etching gas.

Thereby, the etching gas includes Cl₂, so that in the case where the trench side wall protection effect is too strong, it is possible to realize a plasma etching method which can reduce a residual substance at the bottom of the trench which is caused when the protecting effect is achieved up to a bottom of the trench and the etching is partly inhibited.

Further, the fluorine compound gas may be one of sulfur hexafluoride (SF₆) gas and nitrogen trifluoride (NF₃) gas, and in the energizing into plasma state, electricity having a frequency that is equal to or more than 27 MHz may be supplied to the etching gas.

Thereby, progress of the side etching in the trench can be restrained, so that it is possible to realize a plasma etching method by which the side etching is not occurred in the trench and a trench of a predetermined shape can be formed.

Further, the rare gas may be helium (He) gas, and a volume of the helium (He) gas introduced into the treatment chamber may be equal to or more than 80% of a total flow rate of the etching gas.

Thereby, the progress of the side etching in the trench can be further restrained, so that it is possible to realize a plasma etching method by which a trench of a predetermined shape can be formed.

Further, the etching gas further may include polymer forming gas, and the fluorine compound may be sulfur hexafluoride (SF₆) gas, and the polymer forming gas may be one of octafluorocyclobutane (C₄F₈) gas, trifluoromethane (CHF₃) gas, octafluorocyclopentene (C₅F₈) gas, and hexafluorobutadiene (C₄F₆) gas. Further, the fluorine compound gas may be sulfur hexafluoride (SF₆) gas, and in the energizing into plasma state, electricity having a frequency of 500 kHz may be supplied to the etching gas.

Thereby, when the SOI substrate is etched, even after an insulating stopper layer is exposed, the trench sidewall can be continued to be protected, so that it is possible to realize a plasma etching method by which side etching is not occurred in a trench and a trench of a predetermined shape can be formed in a SOI substrate or the like.

Further, the plasma etching method according to the present invention may include etching the object by using etching gas which includes one of oxygen (O₂) gas, carbon monoxide (CO) gas, and carbon dioxide (CO₂) gas, and uses sulfur hexafluoride (SF₆) gas as the fluorine compound gas; and then further etching the object by using etching gas which includes polymer forming gas and uses sulfur hexafluoride (SF₆) gas as the fluorine compound gas.

Thereby, it is possible that, until the insulating stopper layer is exposed due to etching, etching using the O₂ gas is performed to realize a high etching rate, and after the insulating stopper layer is exposed by the etching, etching using the polymer forming gas is performed to realize etching by which progress of side etching becomes small.

Further, the fluorine compound gas may be tetrafluoroethane (CF₄) gas. Further, the rare gas may be Ar gas, and a volume of the Ar gas introduced into the treatment chamber may be 50% to 90% of a total flow rate of the etching gas.

By these structures, reactivity can be reduced and the etching rate can be decreased, so that it is possible to form, with high dimension accuracy, a shallow trench having a high aspect ratio.

### Effect of the Invention

The plasma etching method according to the present invention can, even when a trench having a high aspect ratio is to be formed, restrain the situations where side etching occurs in the trench and where the trench tapers, so that both of the requirement for the trench shape and the requirement for the aspect ratio can be satisfied. Further, it is possible to form a trench having a side wall of a smooth shape. Still further, it is possible to prevent that side etching occurs in the trench and to form a trench of a predetermined shape. Still further, it is possible to form, with high dimension accuracy, a shallow trench having a high aspect ratio.

Thus, according to the present invention, it is possible to provide a plasma etching method by which both of the requirement for the trench shape and the requirement for the aspect ratio can be satisfied, and a trench having a side wall of a smooth shape can be formed, so that the present invention is highly suitable for practical use.

### Brief Description of Drawings

[FIG. 1] FIG. 1 is a diagram showing a structure of a plasma etching device of the first embodiment of the present invention.
[FIG. 2] FIG. 2 is a view for explaining an effect of using helium gas as etching gas in the plasma etching device of the above embodiment.
[FIG. 3A] FIG. 3A is a view for explaining an effect of using an insulating material for an inside wall of an etching chamber, in the plasma etching device of the above embodiment.
[FIG. 3B] FIG. 3B is a view for explaining the effect of using the insulating material for the inside wall of the etching chamber, in the plasma etching device of the above embodiment.
[FIG. 4] FIG. 4 is a view showing a structure of a plasma etching device of the second embodiment of the present invention.
[FIG. 5] FIG. 5 is a graph showing a relationship between a volume of helium and a size of undercut.
[FIG. 6] FIG. 6 is a cross-sectional view of a SOI substrate in which a trench having a notch is formed.
[FIG. 7] FIG. 7 is a view showing a structure of a plasma etching device of the third embodiment of the present invention.
[FIG. 8] FIG. 8 is a view showing a structure of the plasma etching device of the fourth embodiment of the present invention.
[FIG. 9] FIG. 9 is a view for explaining how a trench is formed in a silicon substrate, in the plasma etching device of the above embodiment.
[FIG. 10] FIG. 10 is a cross-sectional view of a silicon substrate in which a trench of a predetermined shape is formed.
[FIG. 11] FIG. 11 is a cross-sectional view of a silicon substrate in which a trench in which side etching occurs is formed.
[FIG. 12A] FIG. 12A is a view for explaining etching of a silicon substrate using the conventional plasma etching method.
[FIG. 12B] FIG. 12B is a view for explaining the etching of the silicon substrate using the conventional plasma etching method.
[FIG. 12C] FIG. 12C is a view for explaining the etching of the silicon substrate using the conventional plasma etching method.
[FIG. 12D] FIG. 12D is a view for explaining the etching of the silicon substrate using the conventional plasma etching method.

### Numerical References

- 100, 1100: Etching chamber
- 110: Upper electrode
- 120: Lower electrode
- 130a, 130b, 730a, 730b, 1030a, 1030b, 1110a, 1110b: High frequency power
- 140, 1120: Gas introducing port
- 150, 1130: Exhaust port
- 300: Mask
- 310, 910, 1150a: Silicon substrate
- 320: Protection film
- 600: Etching chamber wall
- 610: Plasma
- 900: Notch
- 920: Stopper layer
- 1000: Undercut
- 1140: Dielectric coil
- 1150: Electrode
- 1150a: Silicon substrate
- 1160: Dielectric board
- 1170: Heater
- 1180: Chamber heater

### Best Mode for Carrying Out the Invention

The following describes a plasma etching device according to embodiments of the present invention with reference to the drawings.
(First Embodiment)

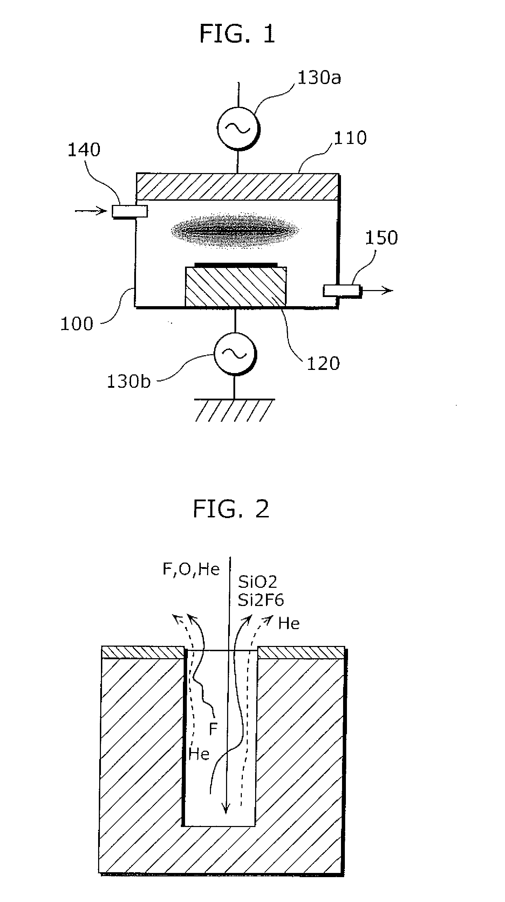

FIG. 1 is a view showing a structure of a plasma etching device of the first embodiment.

The plasma etching device is, for example, an inductively coupled plasma (ICP) etching device, and includes: a vacuum etching chamber 100; an upper electrode 110 and a lower electrode 120 in the etching chamber 100; high frequency powers 130a and 130b; a gas introducing port 140; and an exhaust port 150.

The etching chamber 100 is a treatment chamber where etching is performed, and an inside wall thereof is made of, for example, quartz, alumina, an aluminum matrix with alumite treatment, an insulating material such as yttrium oxide, or the like.

The high frequency powers 130a and 130b supply high-frequency electricity having a frequency of 13.56 MHz, for example.
The gas introducing port 140 supplies gas into the etching chamber 100.

The exhaust port 150 exhausts gas which exists in the etching chamber 100.
Next, a trench processing for a silicon substrate using the above-described plasma etching device, which is one process in manufacturing of a semiconductor device such as a transistor, is described sequentially herein below.

Firstly, on the lower electrode 120 a silicon substrate is placed, and in keeping a constant pressure in the etching chamber 100, etching gas is supplied into the etching chamber 100 through the gas introducing port 140 and exhausted from the exhaust port 150. Note that the etching gas is mixed gas which mainly includes fluorine compound gas, for example sulfur hexafluoride (SF₆) gas, added with added gas, for example oxygen (O₂) gas and rare gas such as helium (He) gas. Note also that, regarding a volume of helium, if the volume is small, a ratio of the SF₆ gas and the O₂ gas in the etching gas becomes large which causes side etching in the trench or tapering of the trench, while if the volume is large, the ratio of the SF₆ gas and the O₂ gas in the etching gas becomes small which fails to make the etching progressed, so that the volume of helium is adjusted to be equal to or more than 30% of a total flow rate. Note also that the added gas may be a carbon compound such as carbon monoxide (CO) or carbon dioxide (CO₂), and the rare gas may be argon (Ar) gas, xenon (Xe) gas, neon (Ne) gas, or krypton (Kr) gas.

Next, from the high frequency powers 130a and 130b, high-frequency electricity are supplied to the upper electrode 110 and the lower electrode 120, respectively, and the etching gas is energized into plasma state. Activated species in the plasma, such as a fluorine F⁺ ion and a fluorine (F) radical, are reacted with a silicon of the silicon substrate to generate reaction products, such as silicon tetrafluoride (SiF₄) and silicon dioxide (SiO₂), and etch the silicon substrate to form a trench. Here, in consideration that the object to be etched is a silicon substrate, radio frequency (RF) power supplied to the lower electrode 120 is set to low, for example, about 50 W.

As described above, the plasma etching device of the first embodiment can, using the etching gas including He gas, form the trench in the silicon substrate. Therefore, as shown in FIG. 2, it is possible to generate gas flow by which gas inside the trench is removed to the outside, and to shorten a stay time of the reaction products and the activated species inside the trench, so that even when a trench is to be formed to have a high aspect ratio that is, for example, equal to or more than 40, the plasma etching device of the first embodiment can restrain situations where side etching occurs in the trench or where the trench tapers. This means that it is possible to realize a plasma etching device which can satisfy both the requirement for the trench shape and the requirement for the aspect ratio.

Further, the plasma etching device of the first embodiment can, by performing the etching process once, form the trench in the silicon substrate. Thereby, it is possible to prevent occurrence of unevenness of the trench side wall, so that the plasma etching device of the first embodiment can be realized as a plasma etching device which can form a trench having a side wall of a smooth shape.

Still further, the plasma etching device of the first embodiment etches the silicon substrate, using the etching gas including O₂ gas. Thereby, a side wall protection effect for the trench can be increased, so that the plasma etching device of the first embodiment can be realized as a plasma etching device which can prevent side etching in the trench and can from a trench of a predetermined shape.

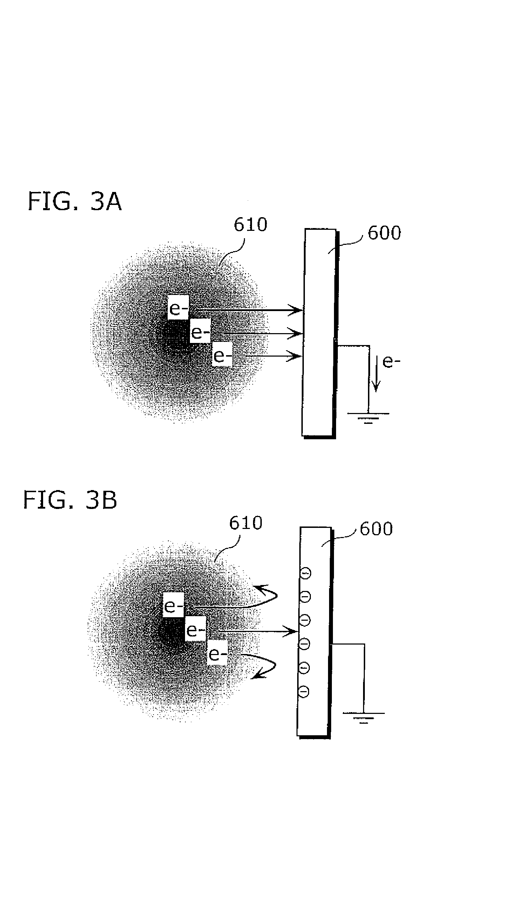

Still further, in the plasma etching device of the first embodiment, an inside wall of the etching chamber 100 is made of an insulating material. Thereby, as shown in FIG. 3A, due to collision of electrons generated by electric discharge on an etching chamber wall 600, a density of plasma 610 does not become low, so that, as shown in FIG. 3B, it is possible to keep the plasma density high and maintains an etching rate high to prevent reduction of the side wall protection effect for the trench, which enables the plasma etching device of the first embodiment to be realized as a plasma etching device which can prevent side etching in the trench and can form a trench of a predetermined shape.

Note that, in the plasma etching device of the first embodiment, the etching gas is mixed gas which mainly includes SF₆ gas added with O₂ gas and rare gas. However, in the etching gas, chlorine (Cl₂) gas, which is, for example, equal to or less than 10%, for example about 10%, of a total flow rate, may be further added. Thereby, in the case where the trench side wall protection effect is too strong, it is possible to reduce a residual substance at the bottom of the trench which is caused when the protecting effect is achieved up to a bottom of the trench and the etching is partly inhibited.

Note also that, in the plasma etching device of the first embodiment, the etching gas mainly includes SF₆ gas, but the etching gas may mainly include nitrogen trifluoride (NF₃) gas.

### (Second Embodiment)

In the above-described plasma etching device of the first embodiment, as etching gas, the mixed gas which includes SF₆ gas, O₂ gas, and rare gas is used, and the mixed gas is applied with electricity having a high frequency of 13.56 MHz, for example. However, if, as etching gas, mixed gas which does not include O₂ gas, namely, mixed gas which includes fluorine compound gas such as SF₆ gas, and rare gas, is used, and the mixed gas is applied with electricity having a high frequency that is equal to or more than 27 MHz, the same effect as described above can be obtained.

Therefore, in a plasma etching device of the second embodiment, as etching gas, mixed gas which includes fluorine compound gas, such as SF₆ gas, and rare gas, is used, and the mixed gas is applied with electricity having a high frequency that is equal to or more than 27 MHz. The following describes mainly features that are different from the features of the first embodiment.

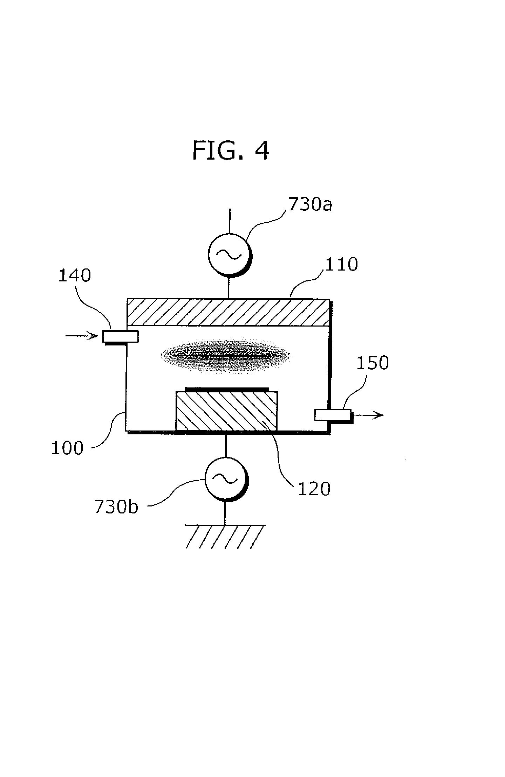

FIG. 4 is a view showing a structure of the plasma etching device of the second embodiment.
The plasma etching device has high frequency powers which are different from the high frequency powers of the plasma etching device of the first embodiment, and includes the etching chamber 100, the upper electrode 110 and the lower electrode 120, high frequency powers 730a and 730b, the gas introducing port 140, and the exhaust port 150.

The high frequency powers 730a and 730b supply high-frequency electricity having a frequency that is equal to or more than 27 MHz, for example, high-frequency electricity having a frequency of 27 MHz with low electric power consumption.

Next, a trench processing for a silicon substrate using the above-described plasma etching device is described sequentially herein below.

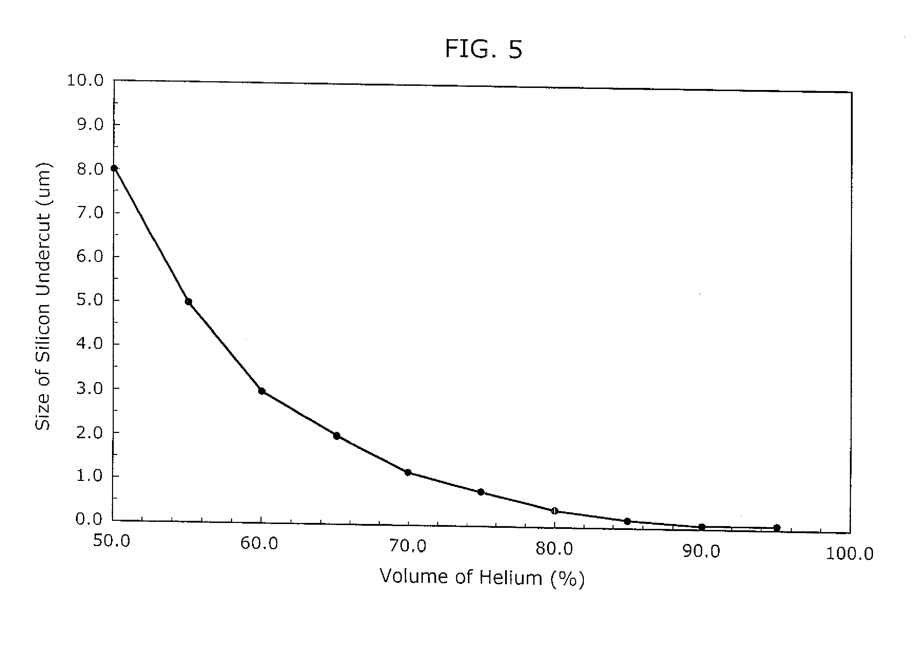

Firstly, on the lower electrode 120 a silicon substrate is placed, and in keeping a constant pressure in the etching chamber 100, etching gas is supplied to the etching chamber 100 through the gas introducing port 140 and exhausted from the exhaust port 150. Note that the etching gas is mixed gas which mainly includes fluorine compound gas, such as SF₆ gas, added with rare gas such as He gas. Note also that a degree of progress of side etching in the trench, in other words, a size of undercut (1000 in FIG. 11) has variations as shown in FIG. 5 corresponding to a volume of helium. More specifically, the progress degree of progress of side etching is getting increased, when the volume of helium becomes less than 80%. Therefore, the volume of helium is adjusted to be equal to or more than 80% of a total flow rate. Note also that the rare gas may be Ar gas or Xe gas.

Next, from the high frequency powers 730a and 730b, high-frequency electricity are supplied to the upper electrode 110 and the lower electrode 120, respectively, and the etching gas is energized into plasma state. Activated species in the plasma, such as a F⁺ ion and a F radical, are reacted with a silicon of the silicon substrate to generate reaction products, such as SiF₄, and etch the silicon substrate to form a trench.

As described above, the plasma etching device of the second embodiment, as well as the plasma etching device of the first embodiment, can be realized as a plasma etching device which can satisfy both the requirement for the trench shape and the requirement for the aspect ratio.

Further, the plasma etching device of the second embodiment, as well as the plasma etching device of the first embodiment, can be realized as a plasma etching device which can form the trench having a side wall of a smooth shape.

Still further, in the plasma etching device of the second embodiment, the etching gas is applied with electricity having a high frequency that is equal to or more than 27 MHz in order to energize the etching gas into plasma state, thereby etching the silicon substrate. Thereby, the progress of side etching in the trench can be restrained, so that the plasma etching device of the second embodiment can be realized as a plasma etching device which can prevent the side etching in the trench and can form a trench of a predetermined shape.

Note that, in the plasma etching device of the second embodiment, the etching gas mainly includes SF₆ gas, but the etching gas may mainly include NF₃ gas.

Note also that, in the plasma etching device of the second embodiment, if, as etching gas, mixed gas, which includes SF₆ gas, O₂ gas, and rare gas, is used, and the mixed gas is applied with electricity having a high frequency that is equal to or more than 27 MHz, the same effect as described above can be obtained.

### (Third Embodiment)

In the above-described plasma etching device of the first embodiment, as etching gas, the mixed gas which includes SF₆ gas, O₂ gas, and rare gas is used. However, if, as etching gas, mixed gas, which includes fluorine compound gas such as SF₆ gas, polymer forming gas, and rare gas, is used, the same effect as described above can be obtained, and furthermore, the progress of side etching can be restrained, when the etching is performed for a silicon substrate, such as a silicon-on-insulator (SOI) substrate, below which an insulating stopper layer is formed.

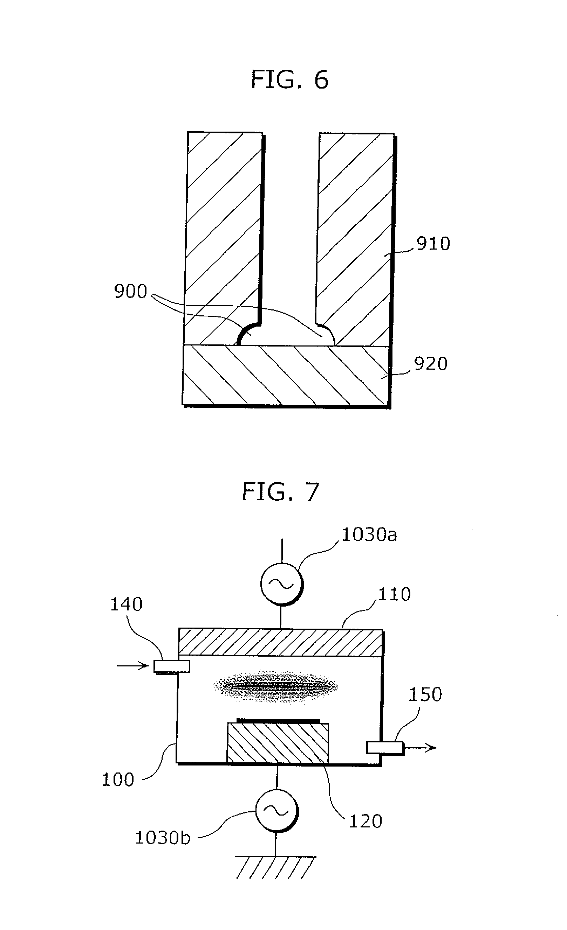

More specifically, the plasma etching device of the first embodiment protects the trench side wall by the reaction products which are generated when oxygen is reacted with silicon. Thereby, when in the SOI substrate or the like, a stopper layer is exposed due to the etching, the generation of the reaction products is stopped and eventually the trench sidewall cannot be protected, so that a notch 900 as shown in FIG. 6 is formed in a silicon substrate 910 adjacent to the stopper layer 920. However, if polymer forming gas is used as the etching gas, by polymers formed by the polymer forming gas, the trench sidewall is protected. Therefore, even if the stopper layer is exposed, the forming of the polymers is not stopped, so that it is possible to continue to protect the trench side wall.

Thus, in the plasma etching device of the third embodiment, as etching gas, mixed gas, which includes fluorine compound gas such as SF₆ gas, the polymer forming gas, and rare gas, is used. The following describes mainly features that are different from the features of the first embodiment. Note that, examples of the polymer forming gas are octafluorocyclobutane (C₄F₈) gas, trifluoromethane (CHF₃) gas, octafluorocyclopentene (C₅F₈) gas, hexafluorobutadiene (C₄F₆) gas, and the like.

FIG. 7 is a view showing a structure of the plasma etching device of the third embodiment.
The plasma etching device has the basically same structure as the plasma etching device of the first embodiment, and includes the etching chamber 100, the upper electrode 110 and the lower electrode 120, high frequency powers 1030a and 1030b, the gas introducing port 140, and the exhaust port 150.

Next, a trench processing for a SOI substrate using the above-described plasma etching device is described sequentially herein below.

Firstly, on the lower electrode 120 a SOI substrate is placed, and in keeping a constant pressure in the etching chamber 100, etching gas is supplied to the etching chamber 100 through the gas introducing port 140 and exhausted from the exhaust port 150. Note that the etching gas is mixed gas which mainly includes fluorine compound gas, such as SF₆ gas, added with polymer forming gas, rare gas such as He gas. Note also that, regarding a volume of helium, if the volume is small, a ratio of the SF₆ gas in the etching gas becomes large which causes side etching in the trench or tapering of the trench, while if the volume is large, the ratio of the SF₆ gas in the etching gas becomes small which fails to make the etching progressed, so that the volume of helium is adjusted to be equal to or more than 30% of a total flow rate. Note also that the rare gas may be Ar gas or Xe gas.

Next, from the high frequency powers 1030a and 1030b, high-frequency electricity are supplied to the upper electrode 110 and the lower electrode 120, respectively, and the etching gas is energized into plasma state. Activated species in the plasma, such as a F⁺ ion and a F radical, are reacted with a silicon of the SOI substrate to generate reaction products, such as hexafluorodisilane (Si₂F₆), and etch a silicon substrate, which is the SOI substrate, until the stopper layer is exposed, and to form a trench.

As described above, the plasma etching device of the third embodiment, as well as the plasma etching device of the first embodiment, can be realized as a plasma etching device which can satisfy both the requirement for the trench shape and the requirement for the aspect ratio.

Further, the plasma etching device of the third embodiment, as well as the plasma etching device of the first embodiment, can be realized as a plasma etching device which can form a trench having a side wall of a smooth shape.

Still further, the plasma etching device of the third embodiment forms a trench in the SOI substrate, using the etching gas which includes the polymer forming gas. Thereby, even after the stopper layer is exposed, it is possible to continue to protect the trench side wall, so that the plasma etching device of the third embodiment can be realized as a plasma etching device which can prevent side etching in the trench and can form a trench of a predetermined shape in a SOI substrate or the like.

Note that it has been described, in the plasma etching device of the third embodiment, that by using, as the etching gas, the mixed gas including SF₆ gas, polymer forming gas, and rare gas, the progress of side etching is restrained, when the etching is performed for the silicon substrate, such as the SOI substrate, below which the stopper layer below is formed. However, even if, as the etching gas, mixed gas which does not include the polymer forming gas, namely, mixed gas which includes fluorine compound gas such as SF₆ gas, and rare gas, is used, when the plasma etching device has a low frequency power which supplies low-frequency electricity having a frequency of 500 kHz, for example, and supplies the low-frequency electricity having a frequency of 500 kHz to the etching gas, the same effect as described above can be obtained.

More specifically, in the plasma etching device of the first embodiment, the high-frequency electricity having a frequency of 13.56 MHz is used, so that a positive ion enters the silicon substrate at a slow speed. Therefore, when in the SOI substrates the stopper layer is exposed due to the etching, by the stopper layer charged with the positive ions which have already entered, a track of positive ion which subsequently enters is changed. However, when electricity having a low frequency having a frequency of 500 kHz is used, the positive ion enters the silicon substrate at a high speed. Therefore, even if in the SOI substrate or the like, the stopper layer is exposed due to the etching, the track of positive ion is not significantly changed, so that it is possible to continue to protect the trench side wall.

Therefore, by supplying electricity having a low frequency of 500 kHz to the etching gas in order to energize the etching gas into plasma state, it is possible to realize a plasma etching device which can form a trench of a predetermined shape in a SOI substrate or the like.

Note that it has been described that the plasma etching device of the third embodiment can be realized as a plasma etching device which can form a trench of a predetermined shape in a SOI substrate or the like, by the above-described etching using the polymer forming gas or the etching using the electricity having a low frequency. However, it is also possible that, until the trench processing is progressed 50% to 90%, for example, etching is performed as described in the first embodiment using, as etching gas, the mixed gas including SF₆ gas, O₂ gas, and rare gas, and after that, for remaining trench processing, the above etching described in the third embodiment is performed using the polymer forming gas or using the electricity having a low frequency.

Thereby, it is possible that, until the insulating stopper layer is exposed by etching, etching using the O₂ gas is performed to realize a high etching rate, and after the stopper layer is exposed by the etching, etching using the polymer forming gas is performed to realize etching by which the progress of side etching becomes small.

Note also that, in the plasma etching device of the third embodiment, the etching gas mainly includes SF₆ gas, but the etching gas may mainly include nitrogen trifluoride (NF₃) gas.

### (Fourth Embodiment)

In the above-described plasma etching device of the first above embodiment, immediately after starting the etching processing, the trench processing is finished before the plasma is stabilized, which causes variations of depth of the trench. Therefore, when a trench is to be formed to have a shallow depth that is, for example, equal to or less than 200 nm, it is necessary to lower an etching rate in order not to let the trench processing be finished before the plasma is stabilized. However, in the plasma etching device of the first embodiment, the etching rate cannot be lower than 50 nm/min, so that when a trench having a shallow depth is to be formed, the trench processing is finished before plasma is stabilized, which fails to form, with high dimension accuracy, a trench having a shallow depth. Here, as a method of lowering the etching rate, a method of reducing the RF power supplied to the lower electrode can be conceived, but when the RF power is reduced, the plasma density becomes low, thereby making it difficult to obtain a desired radical ion and causing instability of electric discharge, so that this method causes a new problem.

Therefore, in the plasma etching device of the fourth embodiment, as etching gas, mixed gas, which includes fluorine compound gas such as SF₄ gas, and rare gas, is used. The following describes mainly features that are different from the features of the first embodiment.

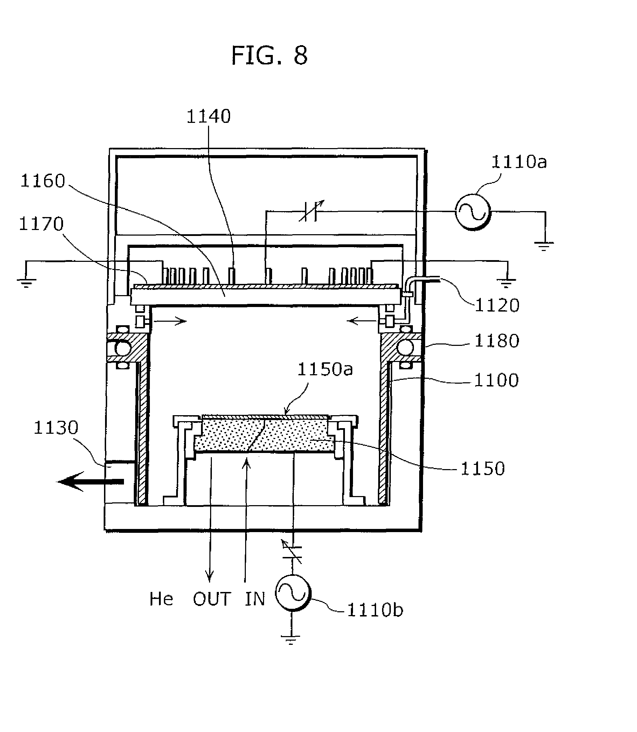

FIG. 8 is a view showing a structure of the plasma etching device of the fourth embodiment.
The plasma etching device is, for example, an ICP etching device, and includes: a vacuum etching chamber 1100; high frequency powers 1110a and 1110b; a gas introducing port 1120; an exhaust port 1130; a dielectric coil 1140 of a spiral antenna shape; an electrode 1150 on which a silicon substrate 1150a is placed; a dielectric board 1160 such as a quartz plate; a heater 1170; and a chamber heater 1180.

The etching chamber 1100 is a treatment chamber where etching is performed,
The high frequency powers 1110a and 1110b supply high-frequency electricity having a frequency of, for example, 13.56 MHz, to the dielectric coil 1140 and the electrode 1150.

The gas introducing port 1120 supplies gas into the etching chamber 1100.
The exhaust port 1130 exhausts gas which exists in the etching chamber 1100.

Next, a trench processing for a silicon substrate using the above-described plasma etching device is described sequentially herein below.

Firstly, on the lower electrode 1150 the silicon substrate 1150a is placed, and in keeping a constant pressure in the etching chamber 1100, etching gas is supplied to the etching chamber 1100 through the gas introducing port 1120 and exhausted from the exhaust port 1130. Note that the etching gas is mixed gas which mainly includes fluorine compound gas, such as tetrafluoroethane (CF₄) gas, added with rare gas such as Ar gas. Note also that, regarding a volume of argon, if the volume is small, a ratio of the CF₄ gas in the etching gas becomes large which causes side etching in the trench or tapering of the trench, while if the volume is large, the ratio of the CF₄ gas in the etching gas becomes small which fails to make the etching progressed, so that the volume of argon is adjusted to be 50% to 90% of a total flow rate. Note also that the rare gas may be He gas, or Xe gas.

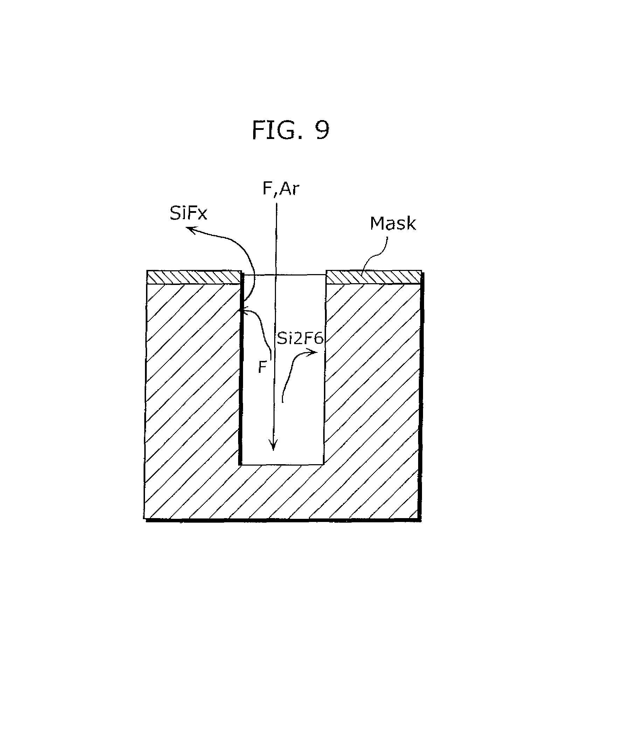

Next, from the high frequency powers 1110a and 1110b, high-frequency electricity are supplied to the dielectric coil 1140 and the electrode 1150, respectively, and the etching gas is energized into plasma state. As shown in FIG. 9, activated species in the plasma, such as a F⁺ ion and a F radical, are reacted with a silicon of the silicon substrate to generate reaction products, such as SiFₓ and Si₂F₆, and etch the silicon substrate to form a trench.

As described above, the plasma etching device of the fourth embodiment can form the trench in the silicon substrate, using the etching gas including Ar gas. Therefore, it is possible to generate gas flow by which gas inside the trench is removed to the outside, and to shorten a stay time of the reaction products and the activated species inside the trench, so that even when a trench is to be formed to have a high aspect ratio that is, for example, equal to or more than 40, the plasma etching device of the fourth embodiment can restrain situations where side etching occurs in the trench or where the trench tapers. This means that it is possible to realize a plasma etching device which can satisfy both the requirement for the trench shape and the requirement for the aspect ratio.

Further, the plasma etching device of the fourth embodiment can form the trench in the silicon substrate, by performing the etching process once. Thereby, it is possible to prevent occurrence of unevenness of the trench side wall, so that the plasma etching device of the fourth embodiment can be realized as a plasma etching device which can form a trench having a side wall of a smooth shape.

Still further, the plasma etching device of the fourth embodiment forms the trench in the silicon substrate, using, as etching gas, the mixed gas which mainly includes CF₄ gas whose degree of dissociating the radical is smaller as compared to SF₆ gas, and is added with Ar gas. Thereby, reactivity can be reduced, and the etching rate can be lower than 50 nm/min, for example, 12 nm/min, so that the plasma etching device of the fourth embodiment can be realized as a plasma etching device which can form, with high dimension accuracy, a trench which has a shallow depth that is equal to or less than 200 nm and has a high aspect ratio. More specifically, when a trench having a depth of 100 nm is to be formed at an etching rate of 2000 nm/min, etching completes within about three seconds, so that in consideration that a time required until the plasma stabilization varies within about one second depending on smaples, the etching depth varies about 30%, which exceeds about 5% that is allowed for the depth variations, but when the trench having a depth of 100 nm is to be formed at an etching rate of 20 nm/min, the etching depth varies about 0.3% using the same calculation, which does not exceed about 5%, so that the plasma etching device of the fourth embodiment can control the etching in a depth direction with significantly high accuracy.

### Industrial Applicability

The present invention can be applied to a plasma etching method, and particularly to etching of a semiconductor substrate during trench processing of the semiconductor device, and the like.

## Claims

**1.** A plasma etching method of performing plasma etching to an object made of silicon in a treatment chamber, said plasma etching method comprising:
introducing, into the treatment chamber, etching gas which includes fluorine compound gas and rare gas; and etching the object by energizing the etching gas into plasma state.

**2.** The plasma etching method according to Claim 1,
wherein the etching gas further includes one of oxygen (O₂) gas, carbon monoxide (CO) gas, and carbon dioxide (CO₂) gas, and
the fluorine compound gas is sulfur hexafluoride (SF₆) gas.

**3.** The plasma etching method according to Claim 2,
wherein the rare gas is helium (He) gas.

**4.** The plasma etching method according to Claim 3,
wherein a volume of the helium (He) gas introduced into the treatment chamber is equal to or more than 30% of a total flow rate of the etching gas.

**5.** The plasma etching method according to Claim 4,
wherein an inside wall of the treatment chamber is made of an insulating material.

**6.** The plasma etching method according to Claim 5,
wherein the insulating material is one of quartz, alumina, an aluminum matrix with alumite treatment, yttrium oxide, silicon carbide, and aluminum nitride.

**7.** The plasma etching method according to Claim 2,
wherein the etching gas further includes chlorine (Cl₂) gas.

**8.** The plasma etching method according to Claim 7,
wherein a volume of the chlorine (Cl₂) gas introduced into the treatment chamber is equal to or less than 10% of a total flow rate of the etching gas.

**9.** The plasma etching method according to Claim 1,
wherein the fluorine compound gas is one of sulfur hexafluoride (SF₆) gas and nitrogen trifluoride (NF₃) gas,
and in said energizing into plasma state, electricity having a frequency that is equal to or more than 27 MHz is supplied to the etching gas.

**10.** The plasma etching method according to Claim 9,
wherein the rare gas is helium (He) gas, and
a volume of the helium (He) gas introduced into the treatment chamber is equal to or more than 80% of a total flow rate of the etching gas.

**11.** The plasma etching method according to Claim 1,
wherein the etching gas further includes polymer forming gas, and
the fluorine compound is sulfur hexafluoride (SF₆) gas.

**12.** The plasma etching method according to Claim 11,
wherein the polymer forming gas is one of octafluorocyclobutane (C₄F₈) gas, trifluoromethane (CHF₃) gas, octafluorocyclopentene (C₅F₈) gas, and hexafluorobutadiene (C₄F₆) gas.

**13.** The plasma etching method according to Claim 1,
wherein the fluorine compound gas is sulfur hexafluoride (SF₆) gas,
and in said energizing into plasma state, electricity having a frequency of 500 kHz is supplied to the etching gas.

**14.** The plasma etching method according to Claim 1, comprising
etching the object by using etching gas which includes one of oxygen (O₂) gas, carbon monoxide (CO) gas, and carbon dioxide (CO₂) gas, and uses sulfur hexafluoride (SF₆) gas as the fluorine compound gas; and then further etching the object by using etching gas which includes polymer forming gas and uses sulfur hexafluoride (SF₆) gas as the fluorine compound gas.

**15.** The plasma etching method according to Claim 1,
wherein the fluorine compound gas is tetrafluoroethane (CF₄) gas.

**16.** The plasma etching method according to Claim 15,
wherein the rare gas is Ar gas.

**17.** The plasma etching method according to Claim 16,
wherein a volume of the Ar gas introduced into the treatment chamber is 50% to 90% of a total flow rate of the etching gas.

**18.** The plasma etching method according to Claim 1,
wherein the etching gas is energized into plasma state by an inductively coupled plasma (ICP) method.

**19.** A device which etches a silicon substrate,
said device forming a trench in the silicon substrate using the plasma etching method according to Claim 1.
